(19) Europäisches Patentamt / European Patent Office / Office européen des brevets

(11) **EP 3 616 482 B1**

(12) **EUROPÄISCHE PATENTSCHRIFT**

(45) Veröffentlichungstag und Bekanntmachung des Hinweises auf die Patenterteilung:
**22.03.2023   Patentblatt 2023/12**

(21) Anmeldenummer: **17742679.8**

(22) Anmeldetag: **11.07.2017**

(51) Internationale Patentklassifikation (IPC):
*H05K 13/08* (2006.01)    *H05K 13/04* (2006.01)
*G05B 19/418* (2006.01)    *G06Q 50/04* (2012.01)
*G06Q 10/06* (2012.01)

(52) Gemeinsame Patentklassifikation (CPC):
**H05K 13/085; G06Q 10/063; G06Q 50/04;**
**H05K 13/0857;** G05B 19/41865; Y02P 90/02;
Y02P 90/30

(86) Internationale Anmeldenummer:
**PCT/EP2017/067363**

(87) Internationale Veröffentlichungsnummer:
**WO 2019/011412 (17.01.2019 Gazette 2019/03)**

(54) **VERFAHREN UND STEUERUNGSEINRICHTUNG ZUR DURCHLAUFZEITOPTIMIERTEN PRODUKTION VON LEITERPLATTEN AUF EINER BESTÜCKUNGSLINIE**

METHOD AND CONTROL DEVICE FOR THE PROCESSING-TIME-OPTIMIZED PRODUCTION OF PRINTED CIRCUIT BOARDS ON AN ASSEMBLY LINE

PROCÉDÉ ET DISPOSITIF DE COMMANDE POUR LA PRODUCTION À DURÉE DE PASSAGE OPTIMISÉE DE CARTES DE CIRCUITS IMPRIMÉS SUR UNE LIGNE DE MONTAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**04.03.2020   Patentblatt 2020/10**

(73) Patentinhaber: **Siemens Aktiengesellschaft**
**80333 München (DE)**

(72) Erfinder:
• **PFAFFINGER, Alexander**
**81739 München (DE)**
• **ROYER, Christian**
**85521Ottobrunn (DE)**

(74) Vertreter: **Siemens Patent Attorneys**
**Postfach 22 16 34**
**80506 München (DE)**

(56) Entgegenhaltungen:
**DE-A1- 19 834 620    DE-A1-102012 221 258**
**DE-A1-102014 222 936    DE-A1-102014 222 940**

**Beschreibung**

Die Erfindung betrifft ein Verfahren zur durchlaufzeitoptimierten Produktion von Leiterplatten auf einer Bestückungslinie. Weiterhin betrifft die Erfindung eine Steuerungseinrichtung für ein Bestückungssystem bzw. eine Fertigungs- oder Montagelinie zur Bestückung von Leiterplatten bzw. Baugruppen mit Bauelementen bzw. Bauteilen. Außerdem betrifft die Erfindung ein Computerprogrammprodukt.

Insbesondere im Bereich der Elektronikproduktion werden zu fertigende Leiterplatten bzw. Baugruppen auf SMT-Bestückungslinien durch Oberflächenmontage (surface mounted technology, SMT) hergestellt. Ein Hersteller von SMT-Bestückungsautomaten (pick and place) und -systeme mit dem Produktnamen SIPLACE ist beispielsweise die Firma ASM (http://www.siplace.com/en/Home).

Mehrere Bestückungsautomaten, die üblicherweise durch ein Transportsystem verbunden sind, und die z.B. zum Fertigen bzw. zum Produzieren von (Elektronik-)bauteilen bzw. Leiterplatten zusammenwirken, stellen eine Bestückungslinie dar.

Bei Bestückungsautomaten z.B. zum Bestücken von Baugruppen mit Bauelementen werden seitlich an einer Transportstrecke für die Baugruppe Wechseltische für Zuführvorrichtungen für Bauelemente angeordnet.

Die Wechseltische umfassen jeweils eine Vielzahl Zuführungseinrichtungen. Jede Zuführungseinrichtung hält einen Vorrat von Bauelementen eines vorbestimmten Bauelementtyps bereit. Für die Bauelemente hat die Zuführungseinrichtung ein Fassungsvermögen (Platzkapazität), das üblicherweise in Spuren bzw. Spurkapazitäten ausgedrückt wird.

Jede Zuführungseinrichtung kann zur Bereithaltung unterschiedlicher Bauelemente konfiguriert werden und üblicherweise können unterschiedliche Zuführungseinrichtungen an einem Wechseltisch angebracht werden. Wird ein Bauelement eines Bauelementtyps an einem bestimmten Bestückungsautomaten benötigt, der nicht in einem der Wechseltische vorhanden ist, so wird üblicherweise nicht einer der angebrachten Wechseltische mit den benötigten Bauelementen versehen, sondern komplett gegen einen anderen, entsprechend bestückten Wechseltisch ausgetauscht. Das Aufrüsten eines einzuwechselnden Wechseltischs mit Bauelementen wird Vorrüstung genannt und kann eine Bearbeitungszeit im Stundenbereich erfordern.

Weiterhin ist es z.B. aus der Elektronikfertigung bekannt, die auf einer Bestückungslinie zu fertigenden Lose in Rüstfamilien zusammenzufassen. Alle Lose einer Rüstfamilie werden jeweils mit derselben Linienrüstung gefertigt. Eine Rüstfamilie, auch Cluster genannt, umfasst eine Menge von Losen, die innerhalb einer Rüstung gefertigt werden kann. Alle Baugruppen einer Rüstfamilie können also nacheinander ohne Umrüsten auf der Bestückungslinie gefertigt werden. Dabei weist jede Baugruppe eine Taktzeit von beispielsweise einer Zeiteinheit 1, 2, 3 etc. in der Produktion bzw. Fertigung auf.

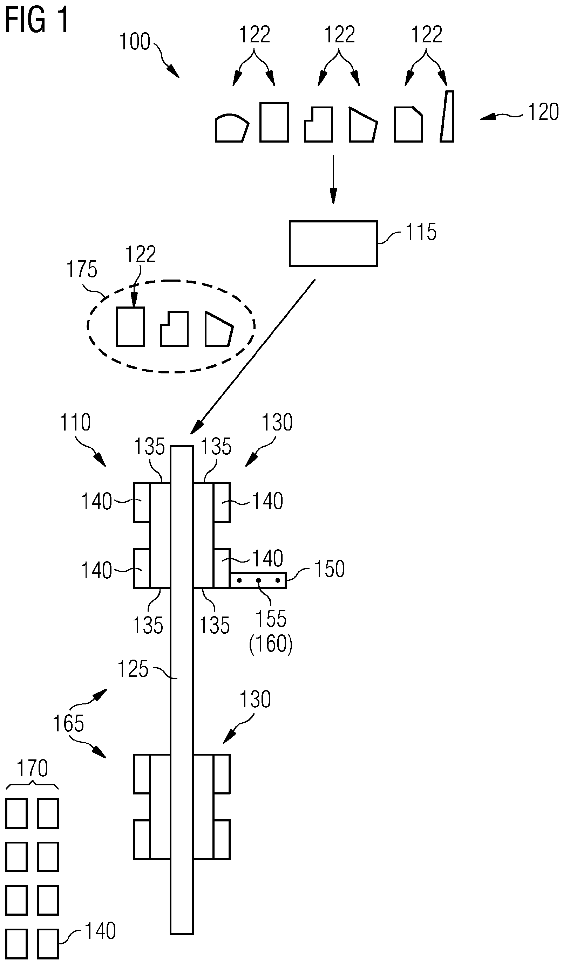

Bei Betrachtung von Figur 1 ist eine Bestückungslinie 110 mit 2 Bestückungsautomaten 130 gezeigt. Es ist ein weiterer solcher Bestückungsautomat auf der Bestückungslinie 110 denkbar. Dann würde bei drei solchen Bestückungsautomaten auf einer Bestückungslinie die Produktionszeit einer Leiterplatte 120 am Ende der Bestückungslinie 30 Sekunden betragen, wenn die Taktzeit einer Baugruppe an einem Bestückungsautomaten 10 Sekunden beträt. Die Taktzeit drückt somit aus, dass alle 10 Sekunden eine weitere Baugruppe am Ende der Bestückungslinie gefertigt herauskommen.

Eine Rüstung kann auf einem oder mehreren Rüsttischen gehalten werden, die leicht am Bestückungsautomaten ausgewechselt werden können. Ein Aufrüsten eines Rüsttischs mit Bauelementen von vorbestimmten Bauelementtypen ist jedoch - wie oben bereits beschrieben - aufwändig. Die Rüstungen werden daher oft in Festrüstungen und Variantenrüstungen unterschieden, wobei ein Festrüstungstisch dazu vorgesehen ist, seine Zusammensetzung von Bauelementtypen über einen vorbestimmten Planungszeitraum zu behalten, während ein Variantenrüsttisch voraussichtlich innerhalb des Planungszeitraums umgerüstet wird.

Der typische Rüstbetrieb an einer SMT-Bestückungslinie innerhalb einer kurzfristigen Planungsperiode, beginnend bei der Planung bis hin zur Ausführung, sieht folgendermaßen aus: Die Dauer eines kurzfristigen Planungszeitraums beträgt normalerweise zwischen ein und fünf Tagen. Zu Beginn einer Planungsperiode erhält der Produktionsplaner gewöhnlich aus einem EDV-System neue Fertigungsaufträge. Er hat aber auch noch einen Restbestand an alten, noch nicht eingeplanten Fertigungsaufträgen aus der Vorperiode. Die Aufträge werden, wenn möglich, mit bestehenden Festrüstungen gefertigt. Für den Rest werden variable Rüstungen (auch Variantenrüstungen genannt) erstellt.

Während mit einer aktiven Rüstung an der Bestückungslinie bestückt wird, wird im Vorrüstbereich bereits die nächste Rüstung auf einem für variable Rüstungen vorgehaltenen Wechseltischsatz vorbereitet. Eine Menge von pro Rüstung notwendigen Wechseltischen wird hierbei als Wechseltischsatz bezeichnet. Dauert die Vorbereitung zu lange, so kommt es zu einer Stillstandzeit der Bestückungslinie.

Auch Umrüstvorgänge für den Rüstwechsel von einer Rüstfamilie auf eine andere Rüstfamilie ziehen Stillstandzeiten von typischerweise 30 min nach sich.

Stillstandzeiten mindern den Durchsatz auf den Bestückungslinien und sollten somit unbedingt vermieden werden.

In der Praxis werden die variablen Rüstungen gewöhnlich mit einem Cluster-Tool wie z.B. SiCluster erstellt. Die in einer zeitlichen Sequenz geordnete Rüstreihenfolge im Vorrüstbereich wird derzeit vom Produktionsplaner manuell erstellt.

Aus PCT/EP2017/051997 ist bereits ein Verfahren bzw. eine Steuerungseinrichtung vorgeschlagen worden, die den Durchsatz auf einer Bestückungslinie optimiert.

Der Durchsatz ist nicht die einzige wichtige Kenngröße für den Betrieb einer Bestückungslinie. Eine weitere ist die Durchlaufzeit, die eine zentrale Größe in der Wertstromtheorie/Lean Manufacturing darstellt.

Die Durchlaufzeit umfasst in dem genannten Umfeld bezogen auf einen Auftrag den Zeitraum von der Übergabe an den Fertigungsbereich bis zur Fertigstellung.

Unter der Durchlaufzeit einer einzelnen Baugruppe/Leiterplatte wird der Zeitraum verstanden von der Übergabe des entsprechenden Fertigungsauftrags an den Fertigungsbereich bis zur Fertigstellung.

Zu den Komponenten der Durchlaufzeit gehören nicht nur die reinen Fertigungszeiten an den einzelnen Bestückungsautomaten, sondern auch (Um)Rüst- und Transportzeiten. Darüber hinaus bilden die Wartezeiten vor den Bestückungsautomaten (sowie gegebenenfalls die Endwartezeit nach der letzten Bestückung) einen wesentlichen Bestandteil (teilweise bis zu 90 %) der Durchlaufzeit.

Den Zusammenhang von Durchsatz und Durchlaufzeit liefert das Gesetz von Little (http://www.wirtschaftslexikon24.com/d/littleschesgesetz/littlesches-gesetz.htm) :

$$DLZ = \frac{WIP}{Durchsatz}$$

wobei:

DLZ: Mittlere Durchlaufzeit [Zeit]
WIP: Mittlerer Bestand an Teilen im Produktionssystem (Work in progress) [Stück]
Durchsatz: Mittlere Produktionsrate an Teilen, die das Produktionssystem verlassen [Stück/Zeit]

Durch die Durchsatz-Maximierung (Reduzieren der Wartezeiten) wird auch die Durchlaufzeit gesenkt.

Bei gleichbleibendem Durchsatz lassen sich jedoch durch zusätzliche Optimierung die Durchlaufzeit und damit der (Lager-)Bestand reduzieren.

Aus DE 10 2014 222 936 A1 ist ein Verfahren zum Bestücken von Leiterplatten mittels einer Bestückungslinie bekannt, wobei mehrere Rüstungen mit jeweils zugeordneten Rüstfamilien gebildet werden. Jeder Rüstung ist eine Anzahl Bauelementetypen und jeder zugeordneten Rüstfamilie eine Anzahl Leiterplattentypen zugeordnet, sodass eine Leiterplatte eines Leiterplattentyps einer Rüstfamilie mittels Bauelementen der Bauelementetypen der Rüstung an der Bestücklinie bestückt werden kann. Ein Rüsttisch mit einem Vorrat von Bauelementen eines Bauelementetyps einer Rüstung kann an der Bestückungslinie bereitgestellt werden. Ein Verfahren zum Bestücken der Leiterplatten umfasst Schritte des Erfassens von Leiterplattentypen, von denen Leiterplatten mit Bauelementen zugeordneter Bauelementetypen bestückt werden sollen, und des Zuordnens von erfassten Leiterplattentypen zu Rüstfamilien. Anschließend wird eine Abfolge bestimmt, in der die Rüstungen der gebildeten Rüstfamilien an der Bestückungslinie gerüstet werden sollen, und die Abfolge wird bezüglich eines vorbestimmten Kriteriums optimiert. Danach können Leiterplatten mittels Rüstungen in der vorbestimmten Abfolge bestückt werden.

Es ist Aufgabe der vorliegenden Erfindung, die Durchlaufzeit auf einer Bestückungslinie zu verbessern.

Diese Aufgabe wird durch die unabhängigen Ansprüche gelöst. Vorteilhafte Weiterbildungen sind Gegenstand der abhängigen Ansprüche.

Die Erfindung beansprucht ein Verfahren zur durchlaufzeitoptimierten Produktion von Leiterplatten auf einer Bestückungslinie, wobei die Leiterplatten jeweils eine Taktzeit in der Produktion aufweisen und in Gruppen aufgeteilt sind, die Cluster genannt werden, wobei ein Cluster jeweils mittels einer Rüstung gefertigt wird, wobei die Rüstung durch an den Bestückungslinien anbringbaren Wechseltische realisiert wird, die jeweils mindestens eine Zuführungseinrichtung zum Bereithalten von Vorräten von Bauelementen aufweisen, wobei eine Menge von pro Rüstung notwendigen Wechseltischen als Wechseltischsatz bezeichnet wird und ein leerer Wechseltischsatz Wechseltische aufweist, deren Zuführungseinrichtungen leer sind, unter den Bedingungen, dass

- eine Rüstung temporär auf leeren Wechseltischsätzen aufgerüstet und nach der Produktion von Leiterplatten durch deren Bestückung abgerüstet wird, und dass
- einer der Wechseltischsätze erst dann in der Produktion einsetzbar ist, wenn er vollständig in einem Vorrüstbereich aufgerüstet worden ist, und der Wechseltischsatz erst dann wieder aufrüstbar ist, wenn die mit dem Wechseltischsatz durchgeführte Produktion beendet und der Wechseltischsatz im Vorrüstbereich wieder abgerüstet worden ist,

wobei das Verfahren folgende Schritte umfasst:

a) Erfassen einer Menge von Clustern,
b) Erfassen einer Anzahl an leeren Wechseltischsätzen
c) Erfassen der jeweiligen Zeitdauer für das Erstellen der Rüstung für ein Cluster,
d) Erfassen einer Anzahl der Leiterplatten innerhalb eines Clusters,
e) Ermitteln der kumulierten Taktzeiten der Leiterplatten innerhalb eines Clusters, wobei das ermittelte Ergebnis der Produktionszeitdauer eines Clusters entspricht,
f) Auswählen einer Reihenfolge der Wechseltischsätze, welche zum Rüsten im Vorrüstbereich mit dem Ziel der Vermeidung von Wartezeiten in der Produktion vewendet werden, in welcher dieselben Wechseltischsätze zur Produktion der Leiterplatten eingesetzt werden,
g) Festlegen einer Reihenfolge der Leiterplatten innerhalb eines Clusters in aufsteigender Reihenfolge gemäß der Taktzeiten der einzelnen Leiterplatten,
h) Optimierung der Reihenfolge der Cluster unter Berücksichtigung der ausgewählten Reihenfolge zur Verwendung der Wechseltischsätze,
i) wobei die durchschnittliche Durchlaufzeit der Leiterplatten aus allen (erfassten) Clustern minimiert wird,
j) Durchführung der Produktion der Leiterplatten mit Hilfe der festgelegten und optimierten Reihenfolgen der Leiterplatten und deren Cluster,

dadurch gekennzeichnet, dass

Verfahren nach dem vorhergehenden Anspruch, dadurch gekennzeichnet, dass zur Minimierung der durchschnittlichen Durchlaufzeiten der Leiterplatten der Cluster die Summe der Anzahl der Leiterplatten eines Cluster multipliziert mit dem Startzeitpunkt des Clusters über alle Cluster minimiert wird.

Ein leerer Wechseltischsatz weist in der Regel ungerüstete bzw. noch nicht gerüstete Wechseltische auf. Die Zuführungseinrichtungen sind dabei leer und nicht mit Bauteilen zur Bestückung gerüstet.

Die Wechseltischsätze können hierbei jeweils an Positionen in einer zeitlichen Reihenfolge, in welcher die Wechseltischsätze im Vorrüstbereich gerüstet werden und in der gleichen zeitlichen Reihenfolge in der Produktion verwendet bzw. eingesetzt werden, zugeordnet werden.

Eine Weiterbildung der Erfindung sieht vor, dass zusätzlich Umrüstzeiten erfasst und in der Produktionszeitdauer berücksichtigt werden, die durch das Wechseln der Wechseltischsätze beim Übergang von einer Rüstung auf eine andere Rüstung auftreten.

Vorzugsweise werden die Berechnungen bzw. Optimierungen der oben genannten Schritte h) und i) mit Hilfe von Gemischt Ganzzahliger Linearer Optimierung durchgeführt wird. Ein mögliches Modell zur Gemischt Ganzzahliger Linearer Optimierung wird im nachstehend erläuterten Ausführungsbeispiel näher beschrieben.

Es können unterschiedliche Typen von Rüstungen verwendet werden, wobei ein erster Typ einer Festrüstung entspricht, die nach einem einmaligen Rüsten unverändert bleibt und vor der Produktion nicht ab- und aufgerüstet wird, sowie pro Festrüstung ein Wechseltischsatz vorgesehen ist, wobei ein zweiter Typ einer Variantenrüstung (V1, ..., V10) entspricht, die gemäß der vorhergehenden Ansprüche veränderbar ist und für die Variantenrüstungen mindestens ein Wechseltischsatz vorgesehen ist und wobei die Leiterplatten jedes Clusters mit einer Rüstung eines vorgebbaren Typs der genannten Typen gefertigt wird.

Um den Durchsatz zu verbessern, können in der Produktion zwischen die Cluster mit Variantenrüstungen geschickt eine oder mehrere Cluster mit Festrüstungen dazwischen geschoben werden. Ein Cluster mit einer Festrüstung kann aufgeteilt werden und mehrfach in die Reihenfolge der Cluster eingebracht werden kann. Zudem kann ein Cluster mit einer Festrüstung zu Beginn und/oder am Ende in die Reihenfolge der Cluster eingebracht werden.

Es ist möglich, dass zur Minimierung der durchschnittlichen Durchlaufzeiten der Leiterplatten der Cluster eine Kostenfunktion berücksichtigt wird, wobei die Kostenfunktion Lagerbestandskosten an Leiterplatten ausdrücken kann.

Die Erfindung bringt den Vorteil mit sich, dass nicht nur der Durchsatz sondern auch die Durchlaufzeit in der Leiterplattenproduktion gesteigert werden kann. Es sind optimale Berechnungen bzw. Ermittlung für die oben Reihenfolgen hinsichtlich der Leiterplatten innerhalb eines Clusters und hinsichtlich der genannten Positionen möglich, wodurch unter anderem auch eine automatisierte Unterstützung in der Produktionsplanung erreicht wird.

Ein weiterer Aspekt der Erfindung ist eine Steuerungseinrichtung, insbesondere zur durchlaufzeitoptimierten Produktion von Leiterplatten (120) auf einer Bestückungslinie (110), wobei die Leiterplatten jeweils eine Taktzeit in der Produktion aufweisen und in Gruppen aufgeteilt sind, die Cluster genannt werden, wobei ein Cluster (175) jeweils mittels einer Rüstung gefertigt wird, wobei die Rüstung durch an den Bestückungslinien anbringbaren Wechseltische (140) realisierbar ist, die jeweils mindestens eine Zuführungseinrichtung (150) zum Bereithalten von Vorräten von Bauelementen (155) aufweisen, wobei eine Menge von pro Rüstung notwendigen Wechseltischen als Wechseltischsatz bezeichnet wird und ein leerer Wechseltischsatz Wechseltische aufweist, deren Zuführungseinrichtungen leer sind, unter den Bedingungen, dass

- eine Rüstung temporär auf leeren Wechseltischsätzen aufgerüstet und nach der Produktion von Leiterplatten durch deren Bestückung abrüstbar ist, und dass

- einer der Wechseltischsätze erst dann in der Produktion einsetzbar ist, wenn er vollständig in einem Vorrüstbereich aufgerüstet worden ist, und der Wechseltischsatz erst dann wieder aufrüstbar ist, wenn die mit dem Wechseltischsatz durchgeführte Produktion beendet und der Wechseltischsatz im Vorrüstbereich wieder abgerüstet worden ist,

wobei die Steuereinheit folgende Erfassungseinrichtungen

a) zum Erfassen einer Menge von Clustern,
b) zum Erfassen einer Anzahl an leeren Wechseltischsätzen
c) zum Erfassen der jeweiligen Zeitdauer für das Erstellen der Rüstung für ein Cluster,
d) zum Erfassen einer Anzahl der Leiterplatten innerhalb eines Clusters, und
e) Mittel zum Ermitteln der kumulierten Taktzeiten der Leiterplatten innerhalb eines Clusters, wobei das ermittelte Ergebnis der Produktionszeitdauer eines Clusters entspricht,
f) Mittel zum Auswählen einer Reihenfolge der Wechseltischsätze, die zum Rüsten im Vorrüstbereich mit dem Ziel der Vermeidung von Wartezeiten in der Produktion verwendet werden, in welcher dieselben Wechseltischsätze zur Produktion der Leiterplatten einsetzbar sind,
g) Mittel zum Festlegen einer Reihenfolge der Leiterplatten innerhalb eines Clusters in aufsteigender Reihenfolge gemäß der Taktzeiten der einzelnen Leiterplatten, und
h) Mittel zur Optimierung der Reihenfolge der Cluster unter Berücksichtigung der ausgewählten Reihenfolge zur Verwendung der Wechseltischsätze,
i) wobei die durchschnittliche Durchlaufzeit der Leiterplatten aus allen (erfassten) Clustern minimiert wird, und
j) Mittel zur Durchführung der Produktion der Leiterplatten mit Hilfe der festgelegten und optimierten Reihenfolgen der Leiterplatten und deren Cluster, aufweist,

dadurch gekennzeichnet, dass
zur Minimierung der durchschnittlichen Durchlaufzeiten der Leiterplatten der Cluster die Summe der Anzahl der Leiterplatten eines Cluster multipliziert mit dem Startzeitpunkt des Clusters über alle Cluster minimiert ist.

Die Steuerungseinrichtung kann Mittel und/oder Einheiten bzw. Einrichtungen und/oder Module zur Durchführung des oben genannten Verfahrens vorsehen, die jeweils hardwaremäßig und/oder firmwaremäßig und/oder softwaremäßig bzw. als Computerprogramm bzw. Computerprogrammprodukt ausgeprägt sein können. Diese Einrichtungen bzw. Mittel können einzeln für sich oder zusammengefasst in ein oder mehreren Einheiten implementiert werden.

Die Steuerungseinrichtung kann wie das oben beschriebene Verfahren entsprechend weitergebildet werden.

Ein weiterer Aspekt der Erfindung kann ein Bestückungssystem sein, das eine solche erfindungsgemäße Steuerungseinrichtung aufweist.

Dieses Bestückungssystem kann Teil einer Anlage sein.

Die Anlage kann unter anderem durch einen der folgenden Anlagentypen charakterisiert sein. Beispiele hierfür sind eine Automatisierungsanlage oder eine Fertigungs- bzw. Produktionsanlage.

Ein weiterer Aspekt der Erfindung ist ein Computerprogrammprodukt bzw. ein Computerprogramm mit Mitteln zur Durchführung des oben genannten Verfahrens, wenn das Computerprogramm (-produkt) in einer oben genannten Steuerungseinrichtung oder in Mitteln der Vorrichtung zur Ausführung gebracht wird. Das Computerprogramm bzw. -produkt kann auf einem computerlesbaren Medium gespeichert sein. Das Computerprogramm bzw. - produkt kann in einer üblichen Programmiersprache (z.B. C++, Java) erstellt sein. Die Verarbeitungseinrichtung kann einen marktüblichen Computer oder Server mit entsprechenden Eingabe-, Ausgabe- und Speichermitteln umfassen. Diese Verarbeitungseinrichtung kann in der Steuerungseinrichtung oder in deren Mitteln integriert sein.

Weitere Vorteile, Einzelheiten und Weiterbildungen der Erfindung ergeben sich aus der nachfolgenden Beschreibung von Ausführungsbeispielen in Verbindung mit den Zeichnungen.

Es zeigen:

Fig. 1    ein Bestückungssystem beispielhaft mit einer Bestückungslinie,

Fig. 2    die Durchlaufzeit einer Baugruppe r der Rüstfamilie bzw. Cluster v,

Fig. 3    ein Beispiel, dass Wartezeiten die Durchlaufzeit erhöhen und

Fig. 4    ein Beispiel zur Verbesserung der Durchlaufzeit bei angenommenen gleichbleibenden Gesamtdurchsatz.

Figur 1 zeigt ein beispielhaftes Bestückungssystem 100. Das Bestückungssystem 100 umfasst eine Bestückungslinie 110 und eine Verarbeitungs- oder Steuerungseinrichtung 115. Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Rüsttisch 140 Bauelemente 155 aufzunehmen und an einen vorbestimmten Platz auf der Leiterplatte bzw. Baugruppe 120 zu positionieren, die sich auf dem Transportsystem 125 befindet. Während des Bestückungsvorgangs steht die Leiterplatte 120 bezüglich des Bestückungsautomaten 130 üblicherweise still.

Die Rüsttische 140 umfassen jeweils eine Vielzahl Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementtyps 160 bereit. Für die Bauelemente 155 hat die Zuführungseinrichtung 150 üblicherweise ein Fassungsvermögen, das in Spuren ausgedrückt werden kann. Eine Spur ist für gewöhnlich 8 mm breit und die Zahl der Spuren eines Rüsttischs 140 ist beschränkt, beispielsweise auf 40. Bauelemente 155 des gleichen Bauelementtyps 160 sind üblicherweise bereitgestellt in einem Gurt, auf einem Tablett oder in einer Röhre. Jeder Bauelementtyp 160 erfordert an der Zuführungseinrichtung 150 und am Rüsttisch 140 eine vorbestimmte Anzahl Spuren, die üblicherweise aneinander angrenzen.

Gewöhnlich kann eine Zuführungseinrichtung 150 zur Bereithaltung von Bauelementen 155 unterschiedlicher Bauelementtypen 160 konfiguriert werden und üblicherweise können unterschiedliche Zuführungseinrichtungen 150 an einem Rüsttisch 140 angebracht werden. Vorliegend wird vereinfachend davon ausgegangen, dass ein Vorrat von Bauelementen 155 eines Bauelementtyps 160 an einer Zuführungseinrichtung 150 praktisch unendlich groß ist, ein Nachrüsten also nicht erforderlich ist.

Wird am Bestückungsautomaten 130 ein Bauelement 155 eines Bauelementtyps 160 benötigt, der nicht an einem der Rüsttische 140 vorhanden ist, so wird üblicherweise nicht die Zuordnung von Bauelementen 155 an einem der angebrachten Rüsttische 140 verändert, sondern der Rüsttisch 140 wird komplett gegen einen anderen, passend bestückten Rüsttisch 140 ausgetauscht. Das Bestücken eines nicht an der Bestückungslinie 110 angebrachten Rüsttischs 140 mit Bauelementen 155 wird Vorrüstung genannt und kann eine Bearbeitungszeit im Bereich von einer oder mehreren Stunden, beispielsweise ca. 6-8 Stunden, erfordern.

Da ein Wechsel von Rüsttischen 140 an der Bestückungslinie 110, ein so genannter Rüstwechsel, üblicherweise mit einem Produktionsstillstand verbunden ist, wird angestrebt, Wechsel der Rüsttische 140 möglichst selten durchzuführen. Da ferner die Rüsttische 140 kostspielig sind und das Umrüsten eines Rüsttischs 140 aufwändig und langwierig sein kann, wird weiter versucht, möglichst wenige Rüstungen zu bilden, um eine vorbestimmte Produktionsmenge von Leiterplatten 120 vorbestimmter Leiterplattentypen 122 zu fertigen. Die Produktionsmenge umfasst hier mehrere Leiterplattentypen 122, von denen jeweils eine vorbestimmte Stückzahl Leiterplatten 120 mit Bauelementen 155 vorbestimmter Bauelementtypen 160 bestückt werden soll. Beispielsweise können 300 Leiterplatten 120 eines ersten Leiterplattentyps 122 und 200 Leiterplatten 120 eines zweiten Leiterplattentyps 122 bestückt werden.

Eine Rüstung 165, 170 umfasst eine Menge von Bauelementtypen 160 und wird realisiert durch einen oder mehrere Rüsttische 140, die bei mehreren Rüsttischen einen Wechseltischsatz bilden und jeweils mit Vorräten von Bauelementen 155 der Bauelementtypen 160 der Rüstung 165, 170 ausgestattet und an der Bestückungslinie 110 angebracht sind.

Der Rüstung 165, 170 ist eine Rüstfamilie 175 zugeordnet, die Leiterplattentypen 122 umfasst, von denen Leiterplatten 120 mittels Bauelementen 155 der Bauelementtypen 160 der Rüstung 165, 170 bestückt werden können. Eine Rüstfamilie 175 ist genau einer Rüstung 165, 170 zugeordnet und umgekehrt.

Um die Auslastung einer Bestückungslinie 110 zu erhöhen oder einen Bedarf an Rüsttischen 140 zu verringern ist es daher entscheidend, wie auf der Basis der zu bestückenden Leiterplattentypen 122 Rüstfamilien 175 gebildet werden. Bei der Bildung von Rüstungen 165, 170 bzw. Rüstfamilien 175 können Nebenbedingungen zu beachten sein, beispielsweise die Einhaltung einer begrenzten Fassungskapazität eines Rüsttisches 140 für Bauelementtypen 160 oder eine Gruppierung vorbestimmter Leiterplattentypen 160 in der gleichen Rüstfamilie 175, etwa aus Gründen der Verwendung bleihaltigen oder bleifreien Lötzinns.

Die Rüstungen können in Festrüstungen 165 und Variantenrüstungen 170 unterschieden werden, wobei eine Festrüstung 165 dazu vorgesehen ist, auf einer Anzahl Wechseltische 140 über einen vorbestimmten Planungszeitraum unverändert gerüstet zu bleiben, während ein Wechseltisch 140 einer Variantenrüstung 170 voraussichtlich innerhalb des Planungszeitraums mit Bauelementen 155 anderer Bauelementtypen 160 umgerüstet wird. Der Planungszeitraum kann beispielsweise 6 bis 12 Monate betragen. Eine Variantenrüstung 165 besteht in einer vorbestimmten Konstellation üblicherweise wesentlich kürzer als der Planungszeitraum, beispielsweise über mehrere Stunden oder Tage, üblicherweise jedoch nicht über mehr als eine Woche.

Die Rüstungen 165, 170 können nach Bedarf an der Bestückungslinie 110 ausgetauscht werden. Um eine Festrüstung 165 oder eine Variantenrüstung 170 zu realisieren wird üblicherweise ein Rüsttisch 140, während er nicht an der Bestückungslinie 110 angebracht ist, mit Vorräten von Bauelementen 155 vorbestimmter Bauelementtypen 160 aufgerüstet. Bereits aufgerüstete Bauelemente 155 nicht benötigter Bauelementtypen 160 können zuvor abgerüstet werden. Diese Umrüstung kann einen erheblichen Anteil manueller Arbeit umfassen und zeitaufwändig sein.

Um den mit einer Variantenrüstung 170 verbundenen Aufwand zu minimieren, wird versucht, in den Festrüstungen 165 möglichst viele Leiterplattentypen 122 aufzunehmen. Ein angestrebter Fall ohne Variantenrüstungen 170 ist in der Praxis jedoch kaum erzielbar.

Die Steuerungseinrichtung 115 ordnet im Rahmen der Steuerung des Bestückungssystems 100 Leiterplattentypen 122, deren zugeordnete Leiterplatten 120 auf der Bestückungslinie 110 bestückt werden sollen, jeweils einer Rüstfamilie 175 zu, wobei Festrüstungs-Rüstfamilien 175, die jeweils einer Festrüstung 165 zugeordnet ist, und Variantenrüstungs-Rüstfamilien 175, die jeweils einer Variantenrüstung 170 zugeordnet sind, gebildet werden können.

Ein Spezialfall von Optimierungsmethoden ist die lineare Optimierung. Sie befasst sich mit der Optimierung linearer Zielfunktionen über einer Menge, die durch lineare Gleichungen und Ungleichungen eingeschränkt ist. Sie ist Grundlage der Lösungsverfahren der (gemischt-) ganzzahligen linearen Optimierung. Ein sogenannter Solver (Löser) ist eine Sammelbezeichnung für spezielle mathematische Computerprogramme, die mathematische Probleme numerisch lösen können. Im Zusammenhang mit MILP (mixed integer linear programing bzw. gemischt ganzzahlige Lineare Programmierung) können für IP-Programme (ganzzahlige Optimierungsmodelle) Standardsolver wie z.B. CPLEX, Scip, Gurobi, Xpress verwendet werden.

Im Folgenden wird ein Beispiel beschrieben, in dem mittels eines MILP-Modell (Mixed Integer Linear Programming) die optimale zeitliche Rüstreihenfolgen von vorgegebenen zu fertigenden Rüstfamilien mit minimaler durchschnittlichen Durchlaufzeit einer Leiterplatte berechnet werden. Zudem kann eine optimale zeitliche Reihenfolge für den Einsatz der gerüsteten Wechseltischsätze (Variantenrüstung) und gegebenfalls der Festrüstungswechseltischsätze an der Bestückungslinie berechnet werden.

Des Weiteren wird eine Reihenfolge der Baugruppen aufsteigend gemäß Ihrer Taktzeiten festgelegt.

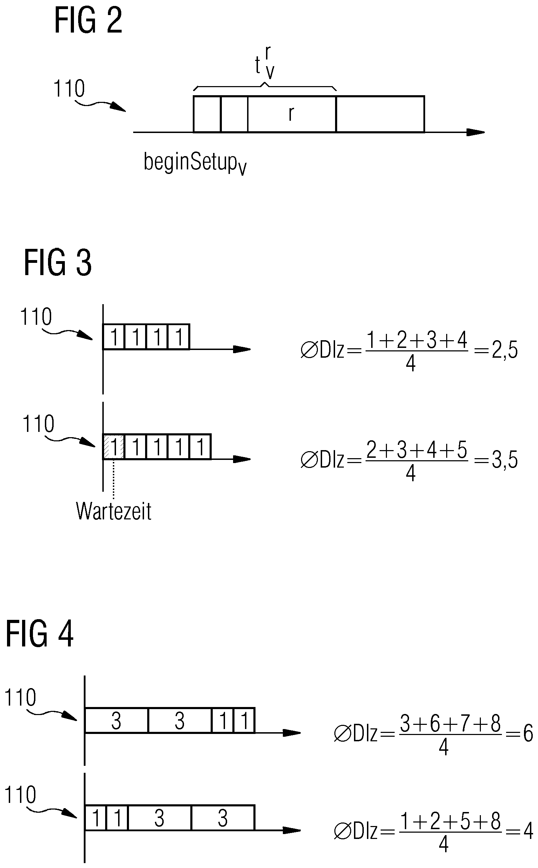

In Figur 2 wird bildlich dargestellt, dass die Durchlaufzeit Dlz einer Baugruppe r der Rüstfamilie v

$$beginSetup_v \ + \ t_v^r$$

beträgt.

In der Figur 3 ist schematisch dargestellt, wie sich Wartezeiten negativ auf die Durchlaufzeit auswirken können. Auf der Bestückungslinie 110 sind beispielhaft vier Leiterplatten mit einer Taktzeit von jeweils einer Zeiteinheit 1 gezeigt. Die durchschnittliche Durchlaufzeit ØDlz beträgt hierbei 2,5 ohne Wartezeit und 3,5 mit Wartezeit.

In Figur 4 ist zeigt sich bei unterschiedlichen Taktzeiten der Baugruppen, dass die Reihenfolge der Baugruppen innerhalb einer Rüstfamilie eine Auswirkung auf die durchschnittliche Durchlaufzeit haben. Im einen Beispiel ergibt sich ØDlz = 6. Im anderen Beispiel und optimierten Fall beträgt ØDlz = 4.

In der Formulierung des Optimierungsmodells in Form eines MILP-Modells gelten die folgenden Bezeichnungen:

Zielfunktion:

$beginSetup_v$ Beginn der Fertigung der Rüstfamilie v

$t_v^r$ Summe aus Wartezeit der Baugruppe r nach Produktionsbeginn der Rüstfamilie und Taktzeit von r

Die Durchlaufzeit einer Baugruppe r der Rüstfamilie v beträgt (siehe Fig. 2):

$$beginSetup_v \ + \ t_v^r$$

Ist $RecipeCount_v$ die Anzahl der Baugruppen in der Rüstfamilie v, beträgt die Summe der Durchlaufzeiten aller Baugruppen einer Rüstfamilie v beträgt dann:

$$sumDlz^v = \sum_{r \in v} beginSetup_v \ + \ t_v^r$$
$$= RecipeCount_v \ beginSetup_v \ + \ \sum_{r \in v} t_v^r$$

Der letzte Term stellt für die Optimierung der Produktionsreihenfolge der Rüstfamilien eine Konstante dar. Die Zielfunktion für die Minimierung der Summe der Durchlaufzeiten der Baugruppen und damit auch für die Minimierung der durchschnittlichen Durchlaufzeit der Baugruppen ist folglich:

$$\text{Minimiere } \sum_{v \in V} \text{RecipeCount}_v \, beginSetup_v$$

Bezeichnungen:

In der MILP-Formulierung gelten die folgenden Bezeichnungen.

Indices

| | |
|---|---|
| v | Menge der zu fertigenden Rüstfamilien |
| P | Menge der Reihenfolge-Positionen für die Rüstfamilien, $P = \{1,..., |V|\}$ , in der Produktionssequenz |
| $T$ | Menge der Tischsätze |
| $P_s$ | *Aufsteigend sortierte* Menge an Positionen, an denen Tischsatz s∈T verwendet wird. |

Parameter

| | |
|---|---|
| $PTime_v$ | Produktionszeitdauer der Rüstfamilie v |
| $RTime_v$ | Zeit für die Erstellung der Rüstung von Rüstfamilie v |
| $EarliestBegin_L$ | Frühestmöglicher Beginn der Produktion an der Bestücklinie |
| $EarliestBegin_R$ | Frühestmöglicher Beginn des Rüstens im Vorrüstbereich |
| $EarliestBegin_s$ | Frühestmöglicher Einsatz für Tischsatz s |
| $RecipeCount_v$ | Anzahl der Baugruppen in der Rüstfamilie |
| v M | $M := \max\{EarliestBegin_L, EarliestBegin_R, EarliestBegin_s : s \in T\} + \sum_{v \in V}(RTime_v + PTime_v)$ |

Variablen

| | |
|---|---|
| $assign_{v,p}$ | Variable, die angibt, ob die Rüstfamilie v an p-ter Position der Fertigungsreihenfolge für die produziert wird. (In diesem Fall nimmt sie den Wert 1 an, anderenfalls den Wert 0) |
| $beginP_p$ | Beginn der Fertigung der Rüstfamilie an p-ter Position der Fertigungsreihenfolge |
| $beginSetup_v$ | Beginn der Fertigung der Rüstfamilie v |
| $beginV_p$ | Beginn der Erstellung der Rüstung für die Rüstfamilie an p-ter Position der Fertigungsreihenfolge im Vorrüstbereich |
| $endP_p$ | Fertigungsende der Rüstfamilie an p-ter Position der Fertigungsreihenfolge |
| $endV_p$ | Ende der Erstellung der Rüstung für die Rüstfamilie an p-ter Position der Fertigungsreihenfolge im Vorrüstbereich |

IP-Formulierung:

Zielfunktion:

$$\text{Minimiere } \sum_{v \in V} \text{RecipeCount}_v \, beginSetup_v$$

Nebenbedingungen:

(1) Jeder Rüstfamilie muss eine Position zugeordnet sein.

$$\sum_{p \in P} \text{assign}_{v,p} = 1, \qquad v \in V$$

(2) Jeder Position muss eine Rüstfamilie zugewiesen sein.

$$\sum_{v \in V} \text{assign}_{v,p} = 1 \qquad p \in P$$

**(3)** Die Produktion einer Rüstfamilie an Position p kann erst beginnen, wenn die Rüstung im Vorrüstbereich erstellt ist.

$$endV_p \leq beginP_p \qquad\qquad p \in P$$

**(4)** Der Rüstvorgang für die Rüstfamilie an Position p kann erst beginnen, wenn der Rüstvorgang für die Rüstfamilie an der Position p-1 abgeschlossen ist.

$$endV_{p-1} \leq beginV_p \qquad\qquad p = 2, \dots, |P|$$

**(5)** Der Rüstvorgang für die Rüstfamilie an der Position p kann im Vorrüstbereich erst beginnen, wenn der zugewiesene Wechseltischsatz frei ist.

$$endP_{p'} \leq beginV_p \qquad\qquad p \text{ direkter Nachfolger von } p' \text{ in } P_s, s \in T$$

**(6)** Berücksichtigung der Produktionszeiten

$$endP_p = beginP_p + \sum_{v \in V} \text{PTime}_v \, assign_{v,p} \qquad p \in P$$

**(7)** Berücksichtigung der Rüstzeiten im Vorrüstbereich

$$endV_p = beginV_p + \sum_{v \in V} \text{RTime}_v \, assign_{v,p} \qquad p \in P$$

**(8)** Die Produktion einer Rüstfamilie an Position p kann erst beginnen, wenn die Produktion der Rüstfamilie an der Position p-1 abgeschlossen ist

$$endP_{p-1} \leq beginP_p \qquad\qquad p = 2, \dots, |P|$$

**(9)** Die Produktion an der Bestücklinie kann initial erst beginnen, wenn die Bestücklinie dafür verfügbar ist.

$$EarliestBegin_L \leq beginP_1$$

(10) Die Rüsterstellung im Vorrüstbereich kann initial erst beginnen, wenn die Bestücklinie dafür verfügbar ist.

$$EarliestBegin_V \leq beginV_1$$

**(11)** Die Rüsterstellung im Vorrüstbereich kann initial erst beginnen, wenn die Bestücklinie dafür verfügbar ist.

$$EarliestBegin_s \leq beginV_p \qquad\qquad p \text{ erstes Element in } P_s$$

**(12)** Der Produktionsbeginn der Rüstfamilie v ist kleinergleich dem Produktionsbeginn der Rüstfamilie an der zugewiesenen Position

$$beginSetup_v \leq beginP_p^L + M(1 - assign_{v,p}) \qquad\qquad v \in V, p \in P$$

**(13)** Der Produktionsbeginn der Rüstfamilie v ist größergleich dem Produktionsbeginn der Rüstfamilie der zugewie-

senen Position

$$beginSetup_v \geq beginP_p - M(1 - assign_{v,p}) \qquad v \in V, p \in P$$

**(14)** Variablenrestriktionen

$$\text{assign}_{v,p} \in \{0,1\} \qquad v \in V, p \in P$$

$$beginP_p^L \geq 0 \qquad p \in P$$

$$beginV_p \geq 0 \qquad p \in P$$

$$beginSetup_v \geq 0 \qquad v \in V$$

$$endP_p \geq 0 \qquad p \in P$$

$$endV_p \geq 0 \qquad p \in P$$

Weiterbildungen/Ausführungsformen:

- Garantie der Durchsatzoptimalität

Minimiert man die durchschnittliche Durchlaufzeit der Baugruppen, so können unter Umständen ungewünschte und vermeidbare Wartezeiten auftreten. Diese lassen sich vermeiden, indem in einer ersten Optimierung zunächst der minimale Fertigungszeitpunkt $T_{min}$ aller Rüstfamilien ermittelt wird und im vorgestellten Verfahren anschließend dann folgende Restriktion mit aufgenommen wird:

$$endP_{|P|} \leq T_{min}$$

- Auftrags-Weitergabe der Baugruppen nach Fertigungsende

Werden nach dem Fertigungsende der Baugruppen die Baugruppen nicht einzeln an die nächste Bearbeitungsstation bzw. Bestückungsautomaten geliefert, sondern wird erst gewartet bis ein ganzer Auftrag (bestehend aus einem Baugruppentyp und der zu fertigenden Stückzahl) fertig ist, so muss zur Minimierung der durchschnittlichen Durchlaufzeit eines Auftrags die Zielfunktion wie folgt abgeändert werden:

$$\text{Minimiere } \sum_{v \in V} \text{RecipeTypeCountT}_v \, beginSetup_v$$

wobei RecipeTypeCount$_v$ die Anzahl der Baugruppentypen umfasst, die in der Rüstfamilie enthalten sind.

- Allgemeinere Kostenfunktion

Die Zielfunktion kann auch eine allgemeinere Kostenfunktion Cost$_v$ enthalten, mit denen z.B. Lagerbestandskosten genauer abgebildet werden.

$$\text{Minimiere } \sum_{v \in V} \text{Cost}_v \, beginSetup_v$$

- Berücksichtigung von Festrüstungen

Festrüstungen und die damit verbundenen Rüstfamilien lassen sich mit in den MILP-Ansatz integrieren. Sie können als Puffer zwischen den Varianten-Rüstfamilien eingesetzt werden, um Stillstandzeiten wegen zu langer Zeiten für die Rüstungserstellung zu vermeiden.

Folgende damit verbundene Erweiterungen sind ebenfalls möglich:

- Berücksichtigung von Umrüstzeiten

Es lassen sich auch Umrüstzeiten, die beim Wechsel von einer zur nächsten Rüstung auftreten, mit im Optimierungsansatz berücksichtigen.

- Bevorzugt Festrüstung am Schluss

Aus dem in (1) beschriebenen Grund ist es zudem günstig, eine Festrüstung am Ende zu fertigen. Dazu kann eine Zielfunktions-Komponente mit einer kleinen Gewichtung mit in die Minimierungs-Zielfunktion aufgenommen werden.

- Mögliche Teilung einer Festrüstung

Die optimale Lösung lässt sich eventuell noch verbessern, wenn man zulässt, dass eine Festrüstungs-Rüstfamilie nicht in einem Stück gefertigt wird, sondern in mehrere Teile aufgeteilt werden kann, die dann jeweils als Puffer zwischen Varianten-Rüstfamilien eingesetzt werden können. Für jeden Teil der Festrüstungs-Rüstfamilie fällt dann allerdings eine entsprechende Umrüstzeit an.

**Patentansprüche**

1. Verfahren zur durchlaufzeitoptimierten Produktion von Leiterplatten auf einer Bestückungslinie (110), wobei die Leiterplatten jeweils eine Taktzeit in der Produktion aufweisen und in Gruppen aufgeteilt sind, die Cluster genannt werden, wobei ein Cluster (175) jeweils mittels einer Rüstung gefertigt wird, wobei die Rüstung durch an den Bestückungslinien anbringbaren Wechseltische (140) realisiert wird, die jeweils mindestens eine Zuführungseinrichtung (150) zum Bereithalten von Vorräten von Bauelementen (155) aufweisen, wobei eine Menge von pro Rüstung notwendigen Wechseltischen als Wechseltischsatz bezeichnet wird und ein leerer Wechseltischsatz Wechseltische aufweist, deren Zuführungseinrichtungen leer sind, unter den Bedingungen, dass

   - eine Rüstung temporär auf leeren Wechseltischsätzen aufgerüstet und nach der Produktion von Leiterplatten durch deren Bestückung abgerüstet wird, und dass
   - einer der Wechseltischsätze erst dann in der Produktion einsetzbar ist, wenn er vollständig in einem Vorrüstbereich aufgerüstet worden ist, und der Wechseltischsatz erst dann wieder aufrüstbar ist, wenn die mit dem Wechseltischsatz durchgeführte Produktion beendet und der Wechseltischsatz im Vorrüstbereich wieder abgerüstet worden ist,

   wobei das Verfahren folgende Schritte umfasst:

   a) Erfassen einer Menge von Clustern,
   b) Erfassen einer Anzahl an leeren Wechseltischsätzen
   c) Erfassen der jeweiligen Zeitdauer für das Erstellen der Rüstung für ein Cluster,
   d) Erfassen einer Anzahl der Leiterplatten innerhalb eines Clusters,
   e) Ermitteln der kumulierten Taktzeiten der Leiterplatten innerhalb eines Clusters, wobei das ermittelte Ergebnis der Produktionszeitdauer eines Clusters entspricht,
   f) Auswählen einer Reihenfolge der Wechseltischsätze, welche zum Rüsten im Vorrüstbereich mit dem Ziel der Vermeidung von Wartezeiten in der Produktion verwendet werden, in welcher dieselben Wechseltischsätze zur Produktion der Leiterplatten eingesetzt werden,
   g) Festlegen einer Reihenfolge der Leiterplatten innerhalb eines Clusters in aufsteigender Reihenfolge gemäß der Taktzeiten der einzelnen Leiterplatten,
   h) Optimierung der Reihenfolge der Cluster unter Berücksichtigung der ausgewählten Reihenfolge zur Verwendung der Wechseltischsätze,
   i) wobei die durchschnittliche Durchlaufzeit der Leiterplatten aus allen (erfassten) Clustern minimiert wird,
   j) Durchführung der Produktion der Leiterplatten mit Hilfe der festgelegten und optimierten Reihenfolgen der Leiterplatten und deren Cluster,

wobei zur Minimierung der durchschnittlichen Durchlaufzeiten der Leiterplatten der Cluster die Summe der Anzahl der Leiterplatten eines Cluster multipliziert mit dem Startzeitpunkt des Clusters über alle Cluster minimiert wird.

2. Verfahren nach Anspruch 1, **dadurch gekennzeichnet, dass** zusätzlich Umrüstzeiten erfasst und in der Produktionszeitdauer berücksichtigt werden, die durch das Wechseln der Wechseltischsätze beim Übergang von einer Rüstung auf eine andere Rüstung auftreten.

3. Verfahren nach einem der vorhergehenden Ansprüche, **dadurch gekennzeichnet, dass** die Schritte h) und i) in Anspruch 1 mit Hilfe von Gemischt Ganzzahliger Linearer Optimierung durchgeführt wird.

4. Verfahren nach einem der vorhergehenden Ansprüche, **dadurch gekennzeichnet, dass** unterschiedliche Typen von Rüstungen verwendet werden, wobei ein erster Typ einer Festrüstung entspricht, die nach einem einmaligen Rüsten unverändert bleibt und vor der Produktion nicht ab- und aufgerüstet wird sowie pro Festrüstung ein Wechseltischsatz vorgesehen ist, wobei ein zweiter Typ einer Variantenrüstung (V1, ..., V10) entspricht, die gemäß der vorhergehenden Ansprüche veränderbar ist und für die Variantenrüstungen mindestens ein Wechseltischsatz vorgesehen ist und wobei die Leiterplatten jedes Clusters mit einer Rüstung eines vorgebbaren Typs der genannten Typen gefertigt wird.

5. Verfahren nach dem vorhergehenden Anspruch, **dadurch gekennzeichnet, dass** ein Cluster mit einer Festrüstung aufgeteilt werden kann und mehrfach in die Reihenfolge der Cluster eingebracht werden kann.

6. Steuerungseinrichtung, insbesondere zur durchlaufzeitoptimierten Produktion von Leiterplatten (120) auf einer Bestückungslinie (110), wobei die Leiterplatten jeweils eine Taktzeit in der Produktion aufweisen und in Gruppen aufgeteilt sind, die Cluster genannt werden, wobei ein Cluster (175) jeweils mittels einer Rüstung gefertigt wird, wobei die Rüstung durch an den Bestückungslinien anbringbaren Wechseltische (140) realisierbar ist, die jeweils mindestens eine Zuführungseinrichtung (150) zum Bereithalten von Vorräten von Bauelementen (155) aufweisen, wobei eine Menge von pro Rüstung notwendigen Wechseltischen als Wechseltischsatz bezeichnet wird und ein leerer Wechseltischsatz Wechseltische aufweist, deren Zuführungseinrichtungen leer sind, unter den Bedingungen, dass

   - eine Rüstung temporär auf leeren Wechseltischsätzen aufgerüstet und nach der Produktion von Leiterplatten durch deren Bestückung abrüstbar ist, und dass
   - einer der Wechseltischsätze erst dann in der Produktion einsetzbar ist, wenn er vollständig in einem Vorrüstbereich aufgerüstet worden ist, und der Wechseltischsatz erst dann wieder aufrüstbar ist, wenn die mit dem Wechseltischsatz durchgeführte Produktion beendet und der Wechseltischsatz im Vorrüstbereich wieder abgerüstet worden ist,

   wobei die Steuereinheit folgende Erfassungseinrichtungen

   a) zum Erfassen einer Menge von Clustern,
   b) zum Erfassen einer Anzahl an leeren Wechseltischsätzen
   c) zum Erfassen der jeweiligen Zeitdauer für das Erstellen der Rüstung für ein Cluster,
   d) zum Erfassen einer Anzahl der Leiterplatten innerhalb eines Clusters, und
   e) Mittel zum Ermitteln der kumulierten Taktzeiten der Leiterplatten innerhalb eines Clusters, wobei das ermittelte Ergebnis der Produktionszeitdauer eines Clusters entspricht,
   f) Mittel zum Auswählen einer Reihenfolge der Wechseltischsätze, welche zum Rüsten im Vorrüstbereich mit dem Ziel der Vermeidung von Wartezeiten in der Produktion verwendet werden, in welcher dieselben Wechseltischsätze zur Produktion der Leiterplatten einsetzbar sind,
   g) Mittel zum Festlegen einer Reihenfolge der Leiterplatten innerhalb eines Clusters in aufsteigender Reihenfolge gemäß der Taktzeiten der einzelnen Leiterplatten, und
   h) Mittel zur Optimierung der Reihenfolge der Cluster unter Berücksichtigung der ausgewählten Reihenfolge zur Verwendung der Wechseltischsätze,
   i) wobei die durchschnittliche Durchlaufzeit der Leiterplatten aus allen erfassten Clustern minimiert wird, und
   j) Mittel zur Durchführung der Produktion der Leiterplatten mit Hilfe der festgelegten und optimierten Reihenfolgen der Leiterplatten und deren Cluster, aufweist,

   wobei zur Minimierung der durchschnittlichen Durchlaufzeiten der Leiterplatten der Cluster die Summe der Anzahl der Leiterplatten eines Clusters multipliziert mit dem Startpunkt des Clusters über alle Cluster minimiert ist.

7.  Steuerungseinrichtung nach Anspruch 6, **dadurch gekennzeichnet, dass** die Steuerungseinrichtung zusätzlich Mittel zum Erfassen von Umrüstzeiten aufweist, die in der Produktionszeitdauer berücksichtigt sind und die durch das Wechseln der Wechseltischsätze beim Übergang von einer Rüstung auf eine andere Rüstung auftreten.

8.  Steuerungseinrichtung nach einem der vorhergehenden Ansprüche 6 oder 7, **dadurch gekennzeichnet, dass** die Mitteln aus h) und i) in Anspruch 9 durch Mittel zur Gemischt Ganzzahliger Linearer Optimierung ausgestaltet sind.

9.  Steuerungseinrichtung nach einem der vorhergehenden Ansprüche 6 bis 8, **dadurch gekennzeichnet, dass** unterschiedliche Typen von Rüstungen verwendbar sind, wobei ein erster Typ einer Feströstung entspricht, die nach einem einmaligen Rüsten unverändert bleibt und vor der Produktion nicht ab- und aufgerüstet wird sowie pro Feströstung ein Wechseltischsatz vorgesehen ist, wobei ein zweiter Typ einer Variantenrüstung (V1, ..., V10) entspricht, die gemäß der vorhergehenden Ansprüche 9 bis 10 veränderbar ist und für die Variantenrüstungen mindestens ein Wechseltischsatz vorgesehen ist und wobei die Leiterplatten jedes Clusters mit einer Rüstung eines vorgebbaren Typs der genannten Typen gefertigt werden kann.

10. Computerprogrammprodukt mit Programmcodemitteln zur Durchführung des Verfahrens nach einem der vorangehenden Verfahrensansprüche, wenn es auf einer Steuerungseinrichtung nach einem der vorangehenden Ansprüche 6 bis 9 abläuft.

**Claims**

1.  Method for the processing-time-optimized production of printed circuit boards on a pick-and-place line (110), wherein the printed circuit boards each have a production cycle time and are divided into groups known as clusters, wherein each cluster (175) is fabricated by means of a setup, wherein the setup is achieved by shuttle tables (140) that are attachable to the pick-and-place lines, which each comprise at least one feed device (150) for providing stores of components (155), wherein a quantity of shuttle tables necessary per setup is designated as shuttle table set and an empty shuttle table set comprises shuttle tables whose feed devices are empty, under the conditions that

    - a setup is temporarily set up on empty shuttle table sets and dismantled after production of printed circuit boards by the assembly thereof, and that
    - one of the shuttle table sets can only be used in production if it has been completely set up in a preliminary setup area and the shuttle table set can only be set up again when the production performed with the shuttle table set has ended and the shuttle table set has been dismantled again in the preliminary setup area,

    wherein the method comprises the following steps:

    a) sensing a quantity of clusters,
    b) sensing a number of empty shuttle table sets,
    c) sensing the respective time for creating the setup for a cluster,
    d) sensing a number of printed circuit boards within a cluster,
    e) determining the cumulative cycle times of the printed circuit boards within a cluster, wherein the determined result corresponds to the production time for a cluster,
    f) selecting an order of the shuttle table sets used for setting up in the preliminary setup area with the aim of avoiding waiting times in production in which these shuttle table sets are used for producing the printed circuit boards,
    g) setting an order of the printed circuit boards within a cluster in ascending order according to the cycle times of the individual printed circuit boards,
    h) optimizing the order of the clusters taking into account the selected order for using the shuttle table sets,
    i) wherein the average processing time of the printed circuit boards from all the (sensed) clusters is minimized,
    j) carrying out the production of the printed circuit boards with the aid of the set and optimized orders of the printed circuit boards and the clusters thereof, wherein

    in order to minimize the average processing times of the printed circuit boards of the clusters, the sum of the number of printed circuit boards of a cluster multiplied by the starting time of the cluster is minimized over all the clusters.

2.  Method according to Claim 1, **characterized in that** in addition changeover times are sensed and taken into account in the production time, which changeover times occur as a result of changing the shuttle table sets on transition from one setup to another setup.

3. Method according to one of the preceding claims, **characterized in that** steps h) and i) in claim 1 are carried out with the aid of mixed integer linear optimization.

4. Method according to one of the preceding claims, **characterized in that** different types of setups are used, wherein a first type corresponds to a fixed setup, which remains unchanged after setting up once and is not dismantled and set up before production and a shuttle table set is provided per fixed setup, wherein a second type corresponds to a variant setup (V1, ..., V10), which is variable according to the preceding claims and at least one shuttle table set is provided for the variant setups, and wherein the printed circuit boards of each cluster are fabricated with a setup of a predefinable type of the said types.

5. Method according to the preceding claim, **characterized in that** one cluster with a fixed setup can be split and can be introduced multiple times into the order of the clusters.

6. Control device, in particular for the processing-time-optimized production of printed circuit boards (120) on a pick-and-place line (110), wherein the printed circuit boards each have a production cycle time and are divided into groups known as clusters, wherein each cluster (175) is fabricated by means of a setup, wherein the setup can be achieved by shuttle tables (140) that are attachable to the pick-and-place lines, which each comprise at least one feed device (150) for providing stores of components (155), wherein a quantity of shuttle tables necessary per setup is designated as shuttle table set and an empty shuttle table set comprises shuttle tables whose feed devices are empty, under the conditions that

- a setup is temporarily set up on empty shuttle table sets and can be dismantled after production of printed circuit boards by the assembly thereof, and that
- one of the shuttle table sets can only be used in production if it has been completely set up in a preliminary setup area and the shuttle table set can only be set up again when the production performed with the shuttle table set has ended and the shuttle table set has been dismantled again in the preliminary setup area,

wherein the control unit comprises the following sensing devices:

a) for sensing a quantity of clusters,
b) for sensing a number of empty shuttle table sets,
c) for sensing the respective time for creating the setup for a cluster,
d) for sensing a number of printed circuit boards within a cluster, and
e) means for determining the cumulative cycle times of the printed circuit boards within a cluster, wherein the determined result corresponds to the production time for a cluster,
f) means for selecting an order of the shuttle table sets used for setting up in the preliminary setup area with the aim of avoiding waiting times in production in which these shuttle table sets can be used for producing printed circuit boards,
g) means for setting an order of the printed circuit boards within a cluster in ascending order according to the cycle times of the individual printed circuit boards, and
h) means for optimizing the order of the clusters taking into account the selected order for using the shuttle table sets,
i) wherein the average processing time of the printed circuit boards from all the sensed clusters is minimized, and
j) means for carrying out the production of the printed circuit boards with the aid of the set and optimized orders of the printed circuit boards and the clusters thereof, wherein in order to minimize the average processing times of the printed circuit boards of the clusters, the sum of the number of printed circuit boards of a cluster multiplied by the starting point of the cluster is minimized over all the clusters.

7. Control device according to Claim 6, **characterized in that** the control device additionally has means for sensing changeover times, which are taken into account in the production time and which occur as a result of changing the shuttle table sets on transition from one setup to another setup.

8. Control device according to either of the preceding Claims 6 and 7, **characterized in that** the means from h) and i) in Claim 9 are configured by means for mixed integer linear optimization.

9. Control device according to one of the preceding Claims 6 to 8, **characterized in that** different types of setups can be used, wherein a first type corresponds to a fixed setup, which remains unchanged after setting up once and is not dismantled and set up before production and a shuttle table set is provided per fixed setup, wherein a second type corresponds to a variant setup (V1, ..., V10), which is variable according to the preceding Claims 9 to 10 and at least one shuttle table set is provided for the variant setups, and wherein the printed circuit boards of each cluster can be fabricated with a setup of a predefinable type of the said types.

**10.** Computer program product with program code means for carrying out the method according to one of the preceding method claims, when it runs on a control device according to one of the preceding Claims 6 to 9.

**Revendications**

**1.** Procédé de production optimisée en fonction du temps de passage de cartes de circuits imprimés sur une ligne de montage (110), dans lequel les cartes de circuits imprimés présentent respectivement un temps de cycle dans la production et sont divisées en groupes qui sont appelés regroupements, dans lequel un regroupement (175) est fabriqué respectivement au moyen d'un équipement, dans lequel l'équipement est réalisé par des plateaux alternants (140) pouvant être montés sur les lignes de montage, qui présentent respectivement au moins un dispositif d'alimentation (150) pour une mise à disposition de stocks de composants (155), dans lequel une quantité de plateaux alternants nécessaires par équipement est désignée comme un jeu de plateaux alternants et dans lequel un jeu de plateaux alternants vide présente des plateaux alternants dont les dispositifs d'alimentation sont vides, dans les conditions où

- un équipement est temporairement équipé de jeux de plateaux alternants vides et déséquipé après la production de cartes de circuits imprimés par leur montage, et
- l'un des jeux de plateaux alternants ne peut être utilisé en production que lorsqu'il a été entièrement équipé dans une zone de prééquipement, et le jeu de plateaux alternants ne peut être rééquipé que lorsque la production effectuée avec le jeu de plateaux alternants a pris fin et le jeu de plateaux alternants a été rééquipé dans la zone de prééquipement,

dans lequel le procédé comprend les étapes suivantes consistant à :

a) détecter une quantité de regroupements ;
b) détecter un nombre de jeux de plateaux alternants vides ;
c) détecter la durée respective pour la création de l'équipement d'un regroupement ;
d) détecter un nombre de cartes de circuits imprimés au sein d'un regroupement ;
e) déterminer les temps de cycle cumulés des cartes de circuits imprimés au sein d'un regroupement, le résultat obtenu correspondant à la durée de production d'un regroupement ;
f) sélectionner un ordre des jeux de plateaux alternants utilisés pour équiper dans la zone de prééquipement dans le but d'éviter les temps d'attente durant la production, dans laquelle les mêmes jeux de plateaux alternants sont utilisés pour la production des cartes de circuits imprimés ;
g) définir un ordre de cartes de circuits imprimés à l'intérieur d'un regroupement par ordre croissant en fonction des temps de cycle de chaque carte de circuits imprimés ;
h) optimiser l'ordre des regroupements en tenant compte de l'ordre sélectionné pour l'utilisation des jeux de plateaux alternants ;
i) dans lequel le temps de passage moyen des cartes de circuits imprimés de tous les regroupements (détectés) est minimisé,
j) réaliser la production des cartes de circuits imprimés à l'aide de l'ordre défini et optimisé des cartes de circuits imprimés et de leurs regroupements ;

dans lequel la somme du nombre des cartes de circuits imprimés d'un regroupement multipliée par le temps de démarrage du regroupement est minimisée sur tous les regroupements afin de minimiser les temps de passage moyens des cartes de circuits imprimés du regroupement.

**2.** Procédé selon la revendication 1, **caractérisé en ce que** les temps de changement d'équipement, qui se produisent à la suite du changement des jeux de plateaux alternants lors du passage d'un équipement à un autre équipement, sont également détectés et pris en compte dans la durée de production.

**3.** Procédé selon l'une quelconque des revendications précédentes, **caractérisé en ce que** les étapes h) et i) de la revendication 1 sont effectuées à l'aide d'un mélange d'optimisation linéaire en nombre entier.

4. Procédé selon l'une quelconque des revendications précédentes, **caractérisé en ce que** différents types d'équipements sont utilisés, dans lequel un premier type correspond à un équipement fixe qui reste inchangé après un équipement unique et qui n'est pas déséquipé et équipé avant la production, et dans lequel un jeu de plateaux alternants est prévu pour chaque équipement fixe, dans lequel un second type correspond à un équipement variable (V1, ..., V10) qui peut être modifié selon les revendications précédentes et pour lequel au moins un jeu de plateaux alternants est prévu pour les équipements variables, et dans lequel les cartes de circuits imprimés de chaque regroupement sont fabriquées avec un équipement d'un type pouvant être défini préalablement desdits types.

5. Procédé selon la revendication précédente, **caractérisé en ce qu'**un regroupement peut être divisé avec un équipement fixe et peut être introduit plusieurs fois dans l'ordre des regroupements.

6. Dispositif de commande, en particulier pour la production optimisée en fonction du temps de passage de cartes de circuits imprimés (120) sur une ligne de montage (110), dans lequel les cartes de circuits imprimés présentent respectivement un temps de cycle dans la production et sont divisées en groupes qui sont appelés regroupements, dans lequel un regroupement (175) est fabriqué respectivement au moyen d'un équipement, dans lequel l'équipement peut être réalisé par des plateaux alternants (140) pouvant être montés sur les lignes de montage, qui présentent respectivement au moins un dispositif d'alimentation (150) pour une mise à disposition de stocks de composants (155), dans lequel une quantité de plateaux alternants nécessaires par équipement est désignée comme un jeu de plateaux alternants et dans lequel un jeu de plateaux alternants vide présente des plateaux alternants dont les dispositifs d'alimentation sont vides, dans les conditions où

- un équipement est temporairement équipé de jeux de plateaux alternants vides et peut être déséquipé après la production de cartes de circuits imprimés par leur montage, et
- l'un des jeux de plateaux alternants ne peut être utilisé en production que lorsqu'il a été entièrement équipé dans une zone de prééquipement, et le jeu de plateaux alternants ne peut être rééquipé que lorsque la production effectuée avec le jeu de plateaux alternants a pris fin et le jeu de plateaux alternants a été rééquipé dans la zone de prééquipement,

dans lequel l'unité de commande présente les dispositifs de détection suivants

a) pour détecter une quantité de regroupements ;
b) pour détecter un nombre de jeux de plateaux alternants vides
c) pour détecter la durée respective pour la création de l'équipement d'un regroupement ;
d) pour détecter un nombre de cartes de circuits imprimés au sein d'un regroupement, et
e) des moyens pour déterminer les temps de cycle cumulés des cartes de circuits imprimés au sein d'un regroupement, le résultat obtenu correspondant à la durée de production d'un regroupement ;
f) des moyens pour sélectionner un ordre des jeux de plateaux alternants utilisés pour équiper dans la zone de prééquipement dans le but d'éviter les temps d'attente durant la production, dans laquelle les mêmes jeux de plateaux alternants peuvent être utilisés pour la production des cartes de circuits imprimés ;
g) des moyens pour définir un ordre de cartes de circuits imprimés à l'intérieur d'un regroupement par ordre croissant en fonction des temps de cycle de chaque carte de circuits imprimés ; et
h) des moyens pour optimiser l'ordre des regroupements en tenant compte de l'ordre sélectionné pour l'utilisation des jeux de plateaux alternants ;
i) dans lequel le temps de passage moyen des circuits imprimés de tous les regroupements détectés est minimisé ; et
j) des moyens pour réaliser la production des cartes de circuits imprimés à l'aide d'ordres définis et optimisés des cartes de circuits imprimés et de leurs regroupement ;

dans lequel la somme du nombre des cartes de circuits imprimés d'un regroupement multipliée par le temps de démarrage du regroupement est minimisée sur tous les regroupements afin de minimiser les temps de passage moyens des cartes de circuits imprimés du regroupement.

7. Dispositif de commande selon la revendication 6, **caractérisé en ce que** le dispositif de commande présente en outre des moyens pour détecter des temps de changement d'équipement qui sont pris en compte dans la durée de production et qui se produisent à la suite du changement des jeux de plateaux alternants lors du passage d'un équipement à un autre équipement.

8. Dispositif de commande selon la revendication 6 ou 7, **caractérisé en ce que** les moyens h) et i) de la revendication 6 sont configurés par des moyens d'optimisation linéaire en nombre entier.

9. Dispositif de commande selon l'une quelconque des revendications précédentes 6 à 8, **caractérisé en ce que** différents types d'équipements peuvent être utilisés, dans lequel un premier type correspond à un équipement fixe qui reste inchangé après un équipement unique et qui n'est pas déséquipé et équipé avant la production, et dans lequel un jeu de plateaux alternants est prévu pour chaque équipement fixe, dans lequel un second type correspond à un équipement variable (V1, ..., V10) qui peut être modifié selon les revendications précédentes 7 à 8 et pour lequel au moins un jeu de plateaux alternants est prévu pour les équipements variables, et dans lequel les cartes de circuits imprimés de chaque regroupement peuvent être fabriquées avec un équipement d'un type pouvant être défini préalablement desdits types.

10. Produit de programme informatique comprenant des moyens de code de programme pour une mise en oeuvre du procédé selon l'une des revendications de procédé précédentes, lorsqu'il est exécuté sur un dispositif de commande selon l'une des revendications précédentes 6 à 9.

FIG 1

# FIG 2

110

$$t_V^r$$

r

$$beginSetup_V$$

# FIG 3

110

| 1 | 1 | 1 | 1 |

$$\varnothing Dlz = \frac{1+2+3+4}{4} = 2{,}5$$

110

| 1 | 1 | 1 | 1 | 1 |

$$\varnothing Dlz = \frac{2+3+4+5}{4} = 3{,}5$$

Wartezeit

# FIG 4

110

| 3 | 3 | 1 | 1 |

$$\varnothing Dlz = \frac{3+6+7+8}{4} = 6$$

110

| 1 | 1 | 3 | 3 |

$$\varnothing Dlz = \frac{1+2+5+8}{4} = 4$$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2017051997 W

- DE 102014222936 A1